# EUROPEAN PATENT APPLICATION

(11) **EP 4 411 806 A1**
(43) Date of publication of application: **07.08.2024**
(21) Application number: 22922620.4
(22) Date of filing: 25.01.2022
(51) Int. Cl.: H01L 23/367, H01L 23/36, H01L 23/28

(54) **PACKAGING DEVICE, POWER MODULE, AND ELECTRONIC DEVICE**

(71) Applicant: Huawei Digital Power Technologies Co., Ltd., Shenzhen, Guangdong 518043 (CN)
(72) Inventor: LIAO, Xiaojing, Shenzhen, Guangdong 518043 (CN)
(74) Representative: Isarpatent
(86) International application number: PCT/CN2022/073848
(87) International publication number: WO 2023/141769

(57) **Abstract**

This application provides a packaged device, a power module, and an electronic apparatus. An outer surface of the packaged device includes a bottom surface and a plurality of side surfaces. The bottom surface of the packaged device faces a circuit board, and an area of at least one side surface is greater than that of the bottom surface. The packaged device includes a chip module, a package body, a first interface, and a second interface. The first interface of the packaged device is configured to connect to the circuit board, and is disposed on the bottom surface. The second interface of the packaged device is configured to connect to a surface-mount device, and disposed on at least one side surface. The packaged device, the power module, and the electronic apparatus provided in this application reduce an area occupied by a circuit board, reduce impact of a parasitic parameter, and improve heat dissipation efficiency. This facilitates miniaturization and efficiency improvement of the packaged device, the power module, and the electronic apparatus.

## Description

### TECHNICAL FIELD

This application relates to the field of chip packaging, and in particular, to a packaged device, a power module, and an electronic apparatus.

### BACKGROUND

A conventional electronic apparatus includes a plurality of electronic devices such as a packaged device, a surface-mount device, and a heat sink. The packaged device, the surface-mount device, and the heat sink in the electronic apparatus are usually disposed on a circuit board in a stacked manner. A long distance between the packaged device and the heat sink results in low heat dissipation effect, and a long distance between the packaged device and the circuit board results in a large parasitic parameter. This affects performance of the electronic apparatus. In some electronic apparatuses, when the packaged device, the surface-mount device, and the heat sink are distributed on the circuit board, an area occupied by the circuit board becomes larger. This is not conducive to miniaturization of the electronic apparatus.

### SUMMARY

Embodiments of this application provide a packaged device, a power module including the packaged device, and an electronic apparatus including the power module, to reduce an area occupied by a circuit board, reduce a parasitic parameter, and improve heat dissipation efficiency.

According to a first aspect, an embodiment of this application provides a packaged device, including a chip module and a package body. The package body is configured to package the chip module. An outer surface of the packaged device includes a bottom surface and a plurality of side surfaces. The packaged device includes a first interface and a second interface. The first interface is configured to connect to a circuit board, and the second interface is configured to connect to a surface-mount device. The first interface is disposed on the bottom surface of the packaged device, or is disposed on a part that is of a first side surface or a second side surface of the packaged device and that is close to the bottom surface. The second interface is disposed on at least one side surface. Each of the first interface and the second interface is electrically connected to the chip module. A bottom surface of the packaged device is disposed facing the circuit board, and an area of at least one side surface is greater than that of the bottom surface.

In an implementation, an outer surface of the packaged device includes a bottom surface and a plurality of side surfaces. The plurality of side surfaces of the packaged device include a first side surface and a second side surface. The first side surface, the bottom surface, and the second side surface are sequentially connected, and an included angle or a rounded angle is formed between the plurality of side surfaces and the bottom surface. Each of an area of the first side surface and an area of the second side surface is greater than the area of the bottom surface. The first interface is disposed on the bottom surface. The second interface is disposed on the second side surface.

It can be understood that, the bottom surface that has a small area and that is of the packaged device is disposed facing the circuit board, and a distance between the packaged device and the circuit board is short. This reduces an area occupied by the circuit board, reduces impact of a parasitic parameter, and facilitates miniaturization of the packaged device. A heat sink can be disposed on a side surface that has a large area and that is of the packaged device, and a distance between the packaged device and the heat sink is short. This reduces thermal resistance, increases a heat dissipation area, improves heat dissipation effect, and facilitates performance improvement of the packaged device.

In an implementation, the first interface is configured to transmit a first type signal. The first type signal includes at least one of the following signal transmitted between the packaged device and the circuit board: a power signal, a ground signal, or a control signal. The first type signal, such as the power signal, the ground signal, or the control signal, is easily affected by a parasitic parameter. A distance between the first interface on the bottom surface of the packaged device and the circuit board is short, and the first type signal is transmitted through the first interface. This can reduce impact of the parasitic parameter, and help improve performance of the packaged device.

In an implementation, the second interface is configured to transmit a second type signal. The second type signal includes at least one of the following signal transmitted between the packaged device and the surface-mount device: a voltage signal or a current signal. The second interface is disposed on a side surface with a large area, so that it is more convenient to connect the surface-mount device to implement an original or extended function of the packaged device. In this way, the packaged device is used in different application scenarios, and practicability of the packaged device can be improved.

In an implementation, the packaged device includes a third interface, and the third interface is electrically connected to the chip module. The third interface is disposed on at least one side surface.

In an implementation, the third interface may be configured to transmit a first type signal or a second type signal, and is configured to provide a parallel line to at least one of the following: the first interface and the second interface. It can be understood that the third interface can provide the parallel line to the packaged device. This can improve reliability of the packaged device.

In an implementation, the first interface of the packaged device is a plug-in interface, configured to connect to the circuit board, and can be configured to support the packaged device. The second interface of the packaged device is a surface-mount interface, and is configured to connect to the surface-mount device.

In an implementation, the plurality of side surfaces of the packaged device include a first side surface and a second side surface, the second interface is disposed on the second side surface, and the third interface is disposed on the first side surface.

Interface types of the first interface, the second interface, and the third interface of the packaged device provided in this application may include one or more of the following: a surface-mount interface, a welding interface, a plug-in interface, or another interface type.

According to a second aspect, an embodiment of this application provides a power module, including the foregoing packaged device and at least one of a heat sink or a surface-mount device. The heat sink is disposed on at least one side surface, and the surface-mount device is connected to a second interface of the packaged device.

In an implementation, the heat sink includes a heat-dissipation body, and the heat-dissipation body is connected to the surface-mount device or the at least one side surface.

In an implementation, a plurality of side surfaces of the packaged device include a first side surface and a second side surface, the heat sink is disposed on the first side surface of the packaged device, and the surface-mount device and the second interface of the packaged device are disposed on the second side surface.

It can be understood that the heat sink is disposed on the first side surface or the second side surface that has a large area and that is of the packaged device. This reduces a distance between the packaged device and the heat sink, reduces thermal resistance between the packaged device and the heat sink, increases an area of contact between the packaged device and the heat sink, and improves heat dissipation effect of the power module. The surface-mount device is disposed on the first side surface or the second side surface that has a large area and that is of the packaged device, so that the surface-mount device can be configured based on different application scenarios. This improves practicability of the power module.

In an implementation, the heat sink includes a support body, one end of the support body is connected to the heat-dissipation body, the surface-mount device, or the at least one side surface, and the other end of the support body is connected to a circuit board. It can be understood that the support body of the heat sink and a first interface of the packaged device can jointly support the power module. This improves structural stability of the power module.

In an implementation, the surface-mount device or the second interface of the packaged device is electrically connected to the circuit board by using the heat sink. In an implementation, the packaged device includes a third interface, and the third interface may be electrically connected to the circuit board by using the heat sink.

It can be understood that the second interface or the third interface of the packaged device can be electrically connected to the circuit board by using the heat sink, and can provide a parallel line to the first interface and the second interface. This improves reliability of the power module.

According to a third aspect, an embodiment of this application provides an electronic apparatus, including a circuit board and the foregoing power module. The power module is disposed on the circuit board, and a packaged device is disposed sideways on the circuit board. The circuit board includes a first connection interface, configured to connect to a first interface of the packaged device.

It can be understood that, in the electronic apparatus in this application, the packaged device of the power module is disposed sideways on the circuit board, and a distance between the packaged device and the circuit board is shortened. This reduces impact of a parasitic parameter, and facilitates performance improvement of the electronic apparatus. The heat sink is disposed on the first side surface or the second side surface that has a large area and that is of the packaged device. This reduces thermal resistance between the packaged device and the heat sink, increases an area of contact between the packaged device and the heat sink, improves heat dissipation effect, and facilitates performance improvement of the electronic apparatus. In other words, the electronic apparatus provided in this application has good heat dissipation effect and a small parasitic parameter. This facilitates performance improvement of the electronic apparatus.

In an implementation, the power module includes a heat sink, the circuit board includes a second connection interface or a third connection interface, and the second connection interface or the third connection interface is configured to connect to a support body of the heat sink. It can be understood that the second connection interface or the third connection interface and the support body of the heat sink may jointly support the power module. This improves structural stability of the electronic apparatus.

In an implementation, the packaged device includes a third interface, and the second connection interface is electrically connected to the third interface of the packaged device by using the heat sink. In an implementation, the power module includes a surface-mount device, and the third connection interface is electrically connected to the surface-mount device or a second interface of the packaged device by using the heat sink. It can be understood that, the second connection interface or the third connection interface of the circuit board in the electronic apparatus in this application can provide a parallel line to the packaged device and the power module. This can improve reliability of the electronic apparatus.

### BRIEF DESCRIPTION OF DRAWINGS

To describe the technical solutions in embodiments of this application or in the background more clearly, the following briefly describes the accompanying drawings for describing embodiments of this application or the background.
FIG. 1a is a schematic diagram of a cross-sectional structure in an embodiment of a conventional electronic apparatus;
FIG. 1b is a schematic diagram of a cross-sectional structure in another embodiment of a conventional electronic apparatus;
FIG. 2 is a schematic diagram of a structure of an electronic apparatus according to an embodiment of this application;
FIG. 3 is a schematic diagram of a cross-sectional structure in an embodiment of an electronic apparatus according to an embodiment of this application;
FIG. 4a is a schematic diagram of a cross-sectional structure in an embodiment of a power module according to an embodiment of this application;
FIG. 4b is a schematic diagram of a cross-sectional structure in an embodiment of a power module according to an embodiment of this application;
FIG. 5 is a schematic diagram of a cross-sectional structure of a heat sink of a power module in an implementation scenario according to an embodiment of this application;
FIG. 6 is a schematic diagram of a cross-sectional structure of a heat sink of a power module in another implementation scenario according to an embodiment of this application;
FIG. 7 is a schematic diagram of a cross-sectional structure in another embodiment of a power module according to an embodiment of this application;
FIG. 8 is a schematic diagram of a cross-sectional structure in still another embodiment of a power module according to an embodiment of this application;
FIG. 9 is a schematic diagram of a cross-sectional structure in yet another embodiment of a power module according to an embodiment of this application; and
FIG. 10 is a schematic diagram of a structure in an embodiment of an electronic apparatus according to an embodiment of this application.

### DESCRIPTION OF EMBODIMENTS

The following describes embodiments of this application with reference to the accompanying drawings in embodiments of this application.

In the descriptions of the embodiments of this application, it should be noted that, unless otherwise specified and limited, terms "installation" and "connection" should be understood in a broad sense. For example, "connection" may be a detachable connection, or may be an unremovable connection, or may be a direct connection, or may be an indirect connection through an intermediate medium. The "fixed connection" means that mutual connection and unchanged relative position relationship after the connection.

It may be understood that the specific embodiments described herein are only used to explain a related invention, but are not intended to limit the present invention. In addition, it should be further noted that, for ease of description, only parts related to the present invention are shown in the accompanying drawings.

It should be noted that embodiments in this application and the features in embodiments may be mutually combined in the case of no conflict.

This application is described in detail in the following with reference to the accompanying drawings by using embodiments.

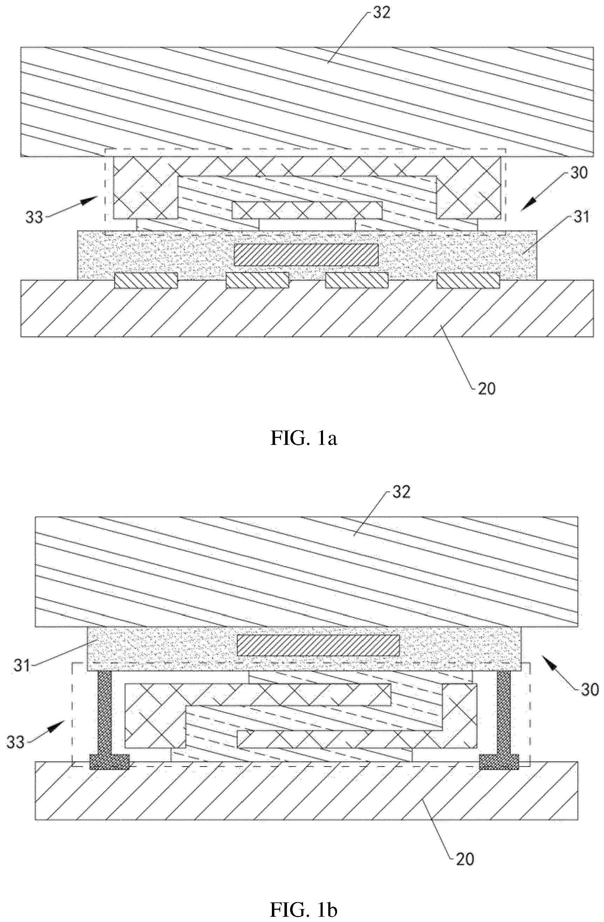

FIG. 1a is a schematic diagram of a cross-sectional structure in an embodiment of a conventional electronic apparatus. As shown in FIG. 1a, the electronic apparatus includes a circuit board 20 and a power module 30. The power module 30 includes a packaged device 31, a heat sink 32, and an inductive element 33. The packaged device 31, the inductive element 33, and the heat sink 32 are sequentially disposed on the circuit board 20 in a stacked manner. The inductive element 33 is disposed between the packaged device 31 and the heat sink 32. In this case, a distance between the packaged device 31 and the heat sink 32 is long; consequently, a thermal resistance between the packaged device 31 and the heat sink 32 is large. This affects heat dissipation of the electronic apparatus.

FIG. 1b is a schematic diagram of a cross-sectional structure in another embodiment of a conventional electronic apparatus. As shown in FIG. 1b, the electronic apparatus includes a circuit board 20 and a power module 30. The power module 30 includes a packaged device 31, a heat sink 32, and an inductive element 33. The inductive element 33, the packaged device 31, and the heat sink 32 are sequentially disposed on the circuit board 20 in a stacked manner, and the inductive element 33 is disposed between the packaged device 31 and the circuit board 20. In this case, a distance between the packaged device 31 and the circuit board 20 is long; consequently, a parasitic parameter between the packaged device 31 and the circuit board 20 is large. This affects performance of the electronic apparatus.

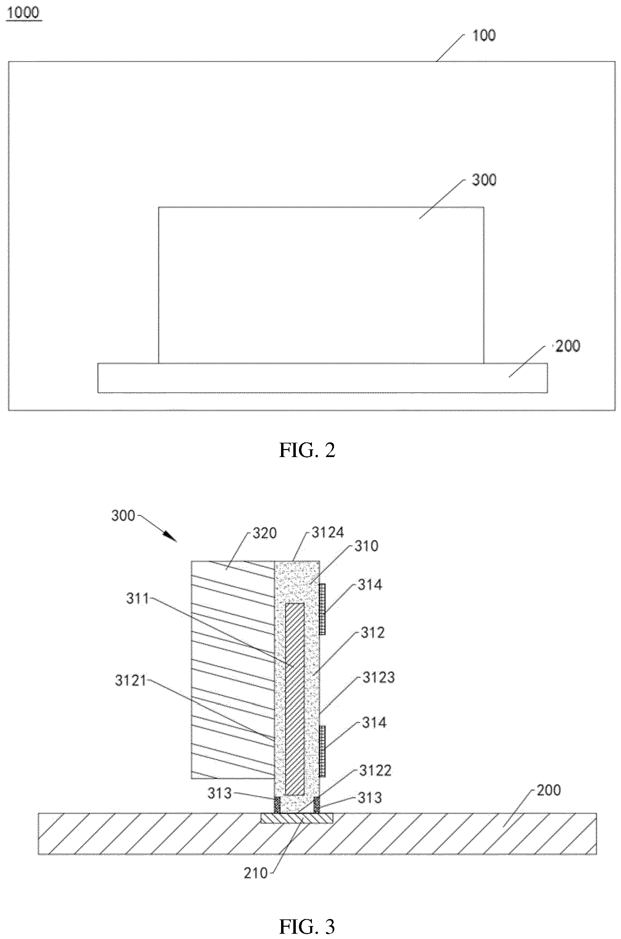

FIG. 2 is a schematic diagram of a structure of an electronic apparatus 1000 according to an embodiment of this application. As shown in FIG. 2, the electronic apparatus 1000 includes a housing 100, a circuit board 200, and a power module 300. The housing 100 is configured to accommodate the circuit board 200 and the power module 300, and the power module 300 is disposed on the circuit board 200. In this embodiment, the circuit board 200 is electrically connected to the power module 300. In some embodiments, each of the power module 300 and the circuit board 200 has an independent electrical network. In some embodiments, the housing 100 may be omitted in the electronic apparatus 1000.

FIG. 3 is a schematic diagram of a cross-sectional structure in an embodiment of an electronic apparatus 1000 according to an embodiment of this application. As shown in FIG. 3, the electronic apparatus 1000 includes a circuit board 200 and a power module 300. In this embodiment, the power module 300 includes a packaged device 310 and a heat sink 320. The packaged device 310 is disposed sideways on the circuit board 200. The heat sink 320 is configured to dissipate heat for the packaged device 310. The packaged device 310 includes a chip module 311, a package body 312, a first interface 313, and a second interface 314.

As shown in FIG. 3, an outer surface of the packaged device 310 includes a bottom surface 3122, a top surface 3124, and a plurality of side surfaces. The plurality of side surfaces of the packaged device 310 include a first side surface 3121, a second side surface 3123, and another side surface that is not shown in the schematic diagram of the cross-sectional structure. The bottom surface 3122 of the packaged device 310 is disposed facing the circuit board 200, the first side surface 3121 and the second side surface 3123 of the packaged device 310 are disposed opposite to each other, the bottom surface 3122 and the top surface 3124 are disposed opposite to each other, and the top surface 3124 is connected between the first side surface 3121 and the second side surface 3123. Each of an area of the first side surface 3121 and an area of the second side surface 3123 is greater than an area of the bottom surface 3122. In this embodiment, the packaged device 310 is a cuboid. Specifically, each of the bottom surface 3122 and the top surface 3124 is parallel to the circuit board 200, an included angle formed between the bottom surface 3122 and each of the first side surface 3121 and the second side surface 3123 is a right angle, and the first side surface 3121 is parallel to the second side surface 3123. The area of the first side surface 3121 and the area of the second side surface 3123 are roughly the same. It may be understood that the cuboid packaged device 310 may be firmly and disposed sideways on the circuit board 200. This facilitates structural stability of the power module 300.

An included angle or a rounded angle may be formed between the bottom surface 3122 and each of the first side surface 3121 and the second side surface 3123 of the packaged device 310 provided in this embodiment of this application. The included angle may include one or more of the following: an acute angle, a right angle, and an obtuse angle. The rounded angle may include one or more radians. In an embodiment, an included angle or a rounded angle formed between the first side surface 3121 and the bottom surface 3122 is the same as that formed between the second side surface 3123 and the bottom surface 3122. In an embodiment, an included angle or a rounded angle formed between the first side surface 3121 and the circuit board 200 is different from that formed between the second side surface 3123 and the circuit board 200. In another embodiment, the bottom surface 3122 and the top surface 3124 may not be parallel, the first side surface 3121 and the second side surface 3123 may not be parallel, the area of the first side surface 3121 and the area of the second side surface 3123 may be different, and the area of the first side surface 3121 or the area the second side surface 3123 is greater than the area of the bottom surface 3122. That is, the area of at least one side surface of the packaged device 310 is greater than the area of the bottom surface 3122.

As shown in FIG. 3, the packaged device 310 includes the chip module 311. The chip module 311 is electrically connected to the first interface 313 and the second interface 314. The chip module 311 may include a chip or another electronic element, or may include a circuit including a combination of a chip and another electronic element. The chip module 311 may include one or more of chips such as a radio frequency chip, an artificial intelligence (Artificial Intelligence, AI) chip, a central processing unit (central processing unit, CPU), and a graphics processing unit (graphics processing unit, GPU). The chip module 311 may include one or more of the following: an insulated gate bipolar transistor (Insulated Gate Bipolar Transistor, IGBT), a metal oxide semiconductor field effect transistor (Metal Oxide Semiconductor Field Effect Transistor, MOSFET), or a transistor of another type. In an embodiment, the chip module 311 includes a signal interface such as a pin or a pad, configured to electrically connect the first interface 313 and the second interface 314.

As shown in FIG. 3, the packaged device 310 includes the package body 312. The package body 312 is configured to package the chip module 311. In this embodiment, the packaged device 310 is a cuboid, and a cross section of the package body 312 is a rectangle. In some embodiments, the cross section of the package body 312 may include various shapes including one or more combinations of a straight line and an arc. Correspondingly, the first side surface 3121 and the second side surface 3123 of the packaged device 310 may be any two of the plurality of side surfaces of the packaged device 310. The first side surface 3121 and the second side surface 3123 may be two adjacent side surfaces or two side surfaces that are spaced from each other. The area of the first side surface 3121 and the area of the second side surface 3123 may be different. The area of the first side surface 3121 or the area of the second side surface 3123 is greater than the area of the bottom surface 3122. That is, the area of at least one side surface of the packaged device 310 is greater than the area of the bottom surface 3122. A material of the package body 312 may include a plastic material, such as epoxy resin or silicone. The package body 312 may be formed through a plastic packaging process. This can improve sealing and reliability of the packaged device 310. In some embodiments, a material of the package body 312 may include a heat conducting material. This can improve heat dissipation effect of the packaged device 310.

As shown in FIG. 3, the packaged device 310 includes a first interface 313, configured to connect to the circuit board 200. In this embodiment, the bottom surface 3122 of the packaged device 310 faces the circuit board 200, the first interface 313 is disposed on the bottom surface 3122 of the packaged device 310, and the packaged device 310 is connected to the circuit board 200 through the first interface 313.

An interface type of the first interface 313 of the packaged device 310 provided in this embodiment of this application may include one or more of the following types: surface-mount, welding, plug-in, pin, or the like. In this embodiment, interface types of the first interface 313 and the second interface 314 are different. The first interface 313 of the packaged device 310 is a plug-in interface, and is configured to connect to the circuit board 200.

For example, the first interface 313 of the packaged device 310 is a plug-in interface. The plug-in interface includes a pin with a diameter of about 50 µm. The first interface 313 may be inserted into a corresponding interface of the circuit board 200, so that not only electrical connection between the packaged device 310 and the circuit board 200 can be implemented, but also fixedly connected between the packaged device 310 and the circuit board 200 can be implemented, and the packaged device 310 can be supported to be disposed sideways on the circuit board 200. That is, the first interface 313 may be configured to implement a plurality of functions such as an electrical connection function, a fixing function, and a support function. In another embodiment, an interface type of the first interface 313 may have only the electrical connection function, and the fixing function or the support function may be implemented by using a support body.

The first interface 313 of the packaged device 310 provided in this embodiment of this application may be disposed on the bottom surface 3122, or disposed on a part that is of at least one side surface and that is close to the bottom surface 3122.

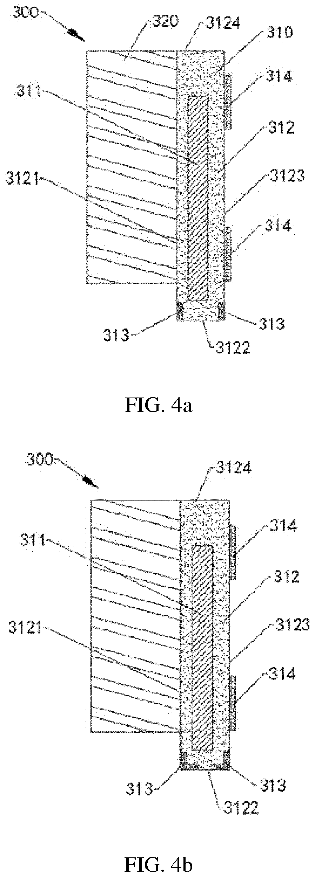

FIG. 4a is a schematic diagram of a cross-sectional structure in an embodiment of a power module 300 according to an embodiment of this application. As shown in FIG. 4a, first interfaces 313 of a packaged device 310 are disposed on parts that are of a first side surface 3121 and a second side surface 3123 and that are close to a bottom surface 3122. In this embodiment, a part of the first interface 313 may extend and be exposed from the bottom surface 3122. This increases a contact area between the first interface 313 and a circuit board 200, and improves reliability of electrical connection between the first interface 313 and the circuit board 200. In some embodiments, the first interface 313 may not be exposed from the bottom surface 3122. In some embodiments, the first interface 313 may be disposed only on a part that is of the first side surface 3121 and that is close to the bottom surface 3122 or on a part that is of the second side surface 3123 and that is close to the bottom surface 3122. That is, the first interface 313 of the packaged device 310 may be disposed on a part that is of at least one side surface and that is close to the bottom surface 3122.

FIG. 4b is a schematic diagram of a cross-sectional structure in an embodiment of a power module 300 according to an embodiment of this application. As shown in FIG. 4b, first interfaces 313 of a packaged device 310 are disposed on a bottom surface 3122. In this embodiment, a part of the first interfaces 313 may extend and be exposed from a first side surface 3121 and a second side surface 3123. This increases a contact area between the first interface 313 and a circuit board 200, and improves reliability of electrical connection between the first interface 313 and the circuit board 200. In some embodiments, the first interface 313 may be not exposed from the first side surface 3121 or the second side surface 3123. That is, the first interface 313 of the packaged device 310 may be disposed on the bottom surface 3122.

The first interface 313 of the packaged device 310 provided in this embodiment of this application is configured to transmit a first type signal. The first type signal includes an input/output signal that is greatly affected by a parasitic parameter. In an embodiment, the first type signal includes at least one of the following signal transmitted between the packaged device 310 and the circuit board 200: a power signal, a ground signal, or a control signal. The power signal includes a main power current, an input/output current, an input/output voltage, and the like. The ground signal includes a power ground signal, an analog ground signal, and the like. The control signal includes a drive signal, a feedback signal, a detection signal, and the like. The first interfaces 313 may include at least one of a ground interface, a power interface, and a control interface. Correspondingly, the ground signal may be transmitted through the ground interface, the power signal may be transmitted through the power interface, and the control signal may be transmitted through the control interface. The first interfaces 313 may include a plurality of interfaces, and the plurality of interfaces may be disposed in a single row or a plurality of rows. For example, as shown in FIG. 4a and FIG. 4b, the first interfaces 313 are disposed in two rows.

The bottom surface 3122 of the packaged device 310 provided in this embodiment of this application faces the circuit board 200, and a distance between the first interface 313 on the bottom surface 3122 and the circuit board 200 is short. This reduces a parasitic parameter of the packaged device 310. For example, a distance between the packaged device 310 and the circuit board 200 is shortened from about 1 mm to about 2 µm, and the parasitic parameter reduces by more than 80%. A distance between the first interface 313 of the packaged device 310 and the circuit board 200 is short. This can reduce impact of the parasitic parameter, and help improve performance of the packaged device 310.

As shown in FIG. 3, the packaged device 310 includes a second interface 314, configured to connect to a surface-mount device. In this embodiment, the second interface 314 is disposed on a second side surface 3123. That is, the second side surface 3123 is provided with the second interface 314. It may be understood that the first side surface 3121 or the second side surface 3123 may be any side surface of the packaged device 310. Correspondingly, the second interface 314 may be disposed on the first side surface 3121 or the second side surface 3123, or may be disposed on both the first side surface 3121 and the second side surface 3123 at the same time. That is, the second interface 314 may be disposed on at least one side surface of the packaged device 310.

An interface type of the second interface 314 of the packaged device 310 provided in this embodiment of this application may include one or more of the following types: surface-mount, welding, plug-in, pin, or the like. In this embodiment, the second interface 314 of the packaged device 310 is a surface-mount interface, and is configured to connect to the surface-mount device, so as to implement an original or extended function of the packaged device 310. In another embodiment, the second interface 314 may also be configured to connect to the circuit board 200 or be configured to connect to another electrical element, a packaged device, or a packaged chip of the circuit board 200.

The second interface 314 of the packaged device 310 provided in this embodiment of this application is configured to transmit a second type signal. The second type signal includes an input/output signal that is less affected by a parasitic parameter. In this embodiment, the second type signal includes at least one of a current signal or a voltage signal transmitted between the packaged device 310 and the surface-mount device.

In comparison with the conventional packaged device, in the packaged device 310 provided in this embodiment of this application, the second interface 314 is disposed on a side surface with a large area, so that the packaged device 310 is connected to various devices through the second interface 314. In this way, an original or extended function of the packaged device 310 can be implemented, the packaged device 310 can be used in different application scenarios, and practicability of the packaged device 310 can be improved.

As shown in FIG. 3, the power module 300 provided in this embodiment of this application includes a heat sink 320. In this embodiment, the heat sink 320 is disposed on the first side surface 3121 of the packaged device 310, and is configured to dissipate heat for the packaged device 310. It may be understood that the first side surface 3121 or the second side surface 3123 may be any side surface of the packaged device 310. Correspondingly, the heat sink 320 may be disposed on the first side surface 3121 or the second side surface 3123, or may be disposed on both the first side surface 3121 and the second side surface 3123 at the same time. That is, the heat sink 320 may be disposed on at least one side surface of the packaged device 310.

The heat sink 320 in the power module 300 provided in this embodiment of this application is connected to the at least one side surface of the packaged device 310, so that thermal resistance between the packaged device 310 and the heat sink 320 can be reduced. In some embodiments, the heat sink 320 may be connected to the first side surface 3121 of the packaged device 310 by welding, bonding, or the like. In another embodiment, all or some of the heat sink 320 may be disposed in the package body 312, to further reduce a distance between the heat sink 320 and the chip module 311. This reduces thermal resistance between the heat sink 320 and the chip module 311, and helps improve heat dissipation efficiency. In addition, all or some of the heat sink 320 is disposed in the package body 312, so that fixed connection between the heat sink 320 and the packaged device 310 is stable. This helps improve structural stability of the power module 300. For example, a distance between the packaged device 310 and the heat sink 320 is shortened from about 1 mm to about 50 µm, and thermal resistance between the packaged device 310 and the heat sink 320 may be reduced by 95% or more.

A material of the heat sink 320 in the power module 300 provided in this embodiment of this application may be copper, aluminum, or another heat conducting material. For example, when the material of the heat sink 320 is copper, heat-conducting property of the copper is good. This helps improve heat dissipation effect of the power module 300. When the material of the heat sink 320 is aluminum, costs of the aluminum are low. This helps reduce costs of the power module 300.

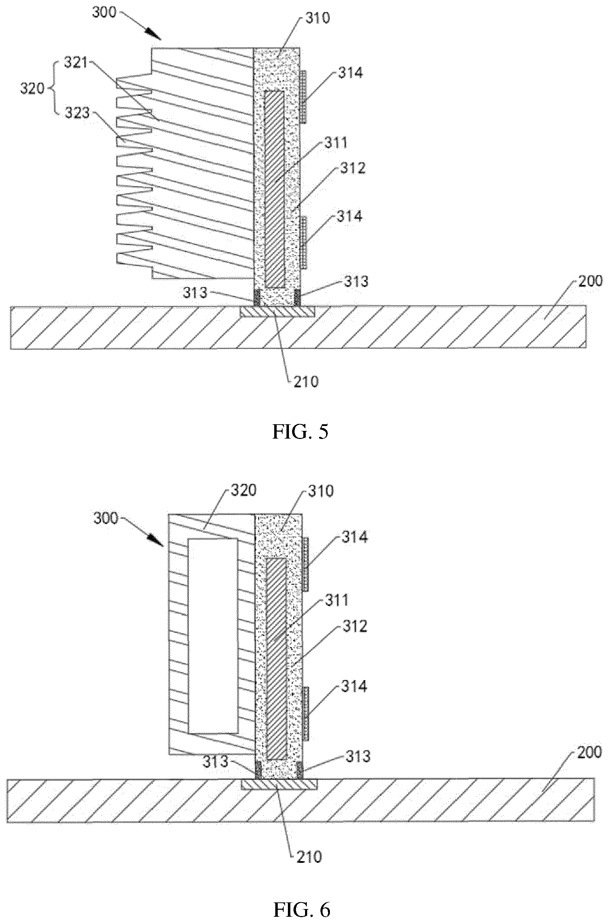

FIG. 5 is a schematic diagram of a cross-sectional structure of a heat sink of a power module in an implementation scenario according to this embodiment of this application. As shown in FIG. 5, a heat sink 320 may include a heat-dissipation body 321 and heat-dissipation fins 323. The heat-dissipation body 321 is fixed on a surface of the packaged device 310, and the heat-dissipation fins 323 are connected to a surface that is of the heat-dissipation body 321 and that is away from the packaged device 310. Heat is distributed from the heat-dissipation body 321 to a plurality of fins of the heat-dissipation fins 323. This helps improve heat dissipation efficiency of the heat sink 320.

FIG. 6 is a schematic diagram of a cross-sectional structure of a heat sink of a power module in another implementation scenario according to this embodiment of this application. As shown in FIG. 6, a circulating water channel may be disposed inside a heat sink 320, so that heat can be quickly taken away, to help improve heat dissipation efficiency of the heat sink 320.

In comparison with the conventional packaged device, a packaged device 310 provided in this embodiment of this application is disposed sideways on a circuit board 200, the packaged device 310 is connected to the circuit board 200 through a bottom surface 3122 with a small area, and the heat sink 320 may be disposed on a side surface with a large area of the packaged device 310. This reduces an occupied area of the circuit board 200, reduces thermal resistance between the packaged device 310 and the heat sink 320, increases a contact area between the packaged device 310 and the heat sink 320, effectively improves heat dissipation effect of the packaged device 310 and the power module 300, and facilitates miniaturization and performance improvement of the packaged device 310 and the power module 300.

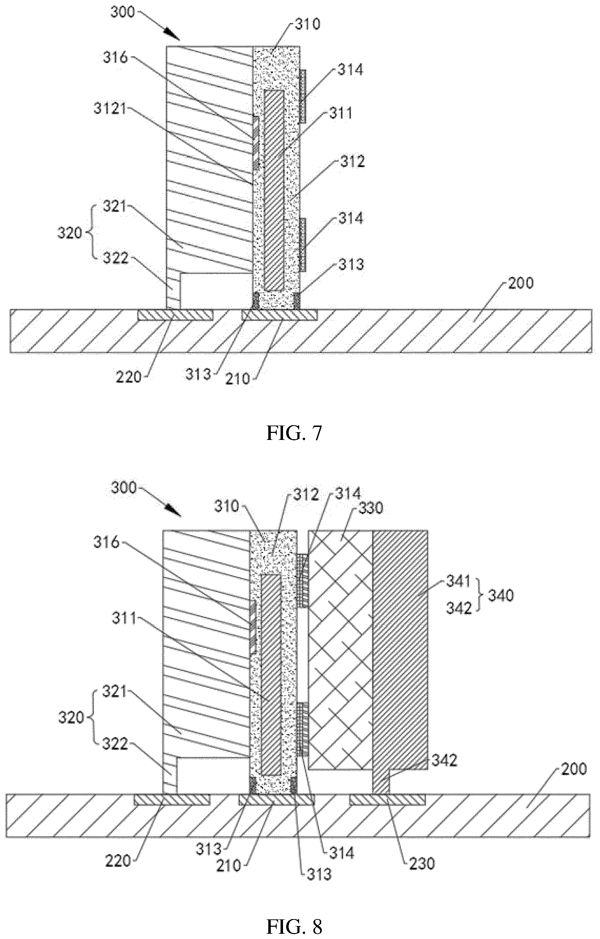

FIG. 7 is a schematic diagram of a cross-sectional structure in another embodiment of a power module according to an embodiment of this application. The structure in this embodiment is roughly the same as the structure shown in FIG. 2, and the same part is not described again.

As shown in FIG. 7, a packaged device 310 includes a third interface 316. The third interface 316 is electrically connected to a chip module 311. In this embodiment, the third interface 316 is disposed on a first side surface 3121. It may be understood that the first side surface 3121 or a second side surface 3123 may be any side surface of the packaged device 310. Correspondingly, the third interface 316 may be disposed on the first side surface 3121 or the second side surface 3123, or may be disposed on both the first side surface 3121 and the second side surface 3123 at the same time. That is, the third interface 316 may be disposed on at least one side surface of the packaged device 310.

A signal transmitted by the third interface 316 of the packaged device 310 provided in this embodiment of this application may be the same as a signal transmitted by a first interface 313 or a second interface 314. That is, the third interface 316 of the packaged device 310 may be configured to transmit at least one of a first type signal or a second type signal. The first interface 313 of the packaged device 310 may include at least one of a ground interface, a power interface, and a control interface. Correspondingly, the third interface 316 may include at least one of a ground interface, a power signal interface, and a control signal interface.

For example, the first interface 313 and the third interface 316 of the packaged device 310 each include the ground interface, and signals transmitted by the first interface 313 and the third interface 316 of the packaged device 310 are the same. The first interface 313 of the packaged device 310 may be electrically connected to the circuit board 200, and the first interface 313 is electrically connected to the circuit board 200 to form a first ground line. The third interface 316 of the packaged device 310 may be electrically connected to the circuit board 200, and the third interface 316 is electrically connected to the circuit board 200 to form a second ground line. Correspondingly, the first ground line and the second ground line may form a parallel line. That is, the third interface 316 of the packaged device 310 may provide the parallel line to the first interface 313. This can improve reliability of the packaged device 310 and the power module 300.

Similarly, signals transmitted by the third interface 316 and the second interface 314 of the packaged device 310 may be the same. The third interface 31 of the packaged device 310 may also provide the parallel line to the second interface 314. That is, the third interface 316 of the packaged device 310 may provide the parallel line to the first interface 313 or the second interface 314.

In comparison with the conventional packaged device, the third interface 316 of the packaged device 310 provided in this embodiment of this application may provide the parallel line to the first interface 313 or the second interface 314. This improves reliability of the packaged device 310.

Alternatively, a signal transmitted by the third interface 316 of the packaged device 310 provided in this embodiment of this application may not the first type signal or the second type signal. In this way, another function of the packaged device 310 is implemented. An interface type of the third interface 316 of the packaged device 310 provided in this embodiment of this application may include one or more of the following types: surface-mount, welding, plug-in, pin, or the like.

As shown in FIG. 7, the power module 300 includes a heat sink 320. The heat sink 320 is disposed on the first side surface 3121 of the packaged device 310. That is, the first side surface 3121 of the packaged device 310 is provided with the heat sink 320.

In this embodiment, the heat sink 320 includes a heat-dissipation body 321 and a support body 322. In an embodiment, the heat-dissipation body 321 and the support body 322 of the heat sink 320 are connected to each other. Specifically, the heat-dissipation body 321 is connected to the first side surface 3121 of the packaged device 310, one end that is of the support body 322 and that is close to the packaged device 310 is connected to the heat-dissipation body 321, and the other end that is of the support body 322 and that is close to the circuit board 200 is connected to the circuit board 200. In another embodiment, the heat-dissipation body 321 and the support body 322 of the heat sink 320 are separated from each other. Specifically, the heat-dissipation body 321 is connected to the first side surface 3121 of the packaged device 310, one end that is of the support body 322 and that is close to the packaged device 310 is connected to the first side surface 3121 of the packaged device 310, and the other end that is of the support body 322 and that is close to the circuit board 200 is connected to the circuit board 200. That is, the one end of that is of the support body 322 and that is close to the packaged device 310 may be connected to the heat-dissipation body 321 or the first side surface 3121 of the packaged device 310, and the other end that is of the support body 322 and that is close to the circuit board 200 may be connected to the circuit board 200.

In another embodiment, the heat-dissipation body 321 may be omitted in the heat sink 320. Specifically, one end that is of the support body 322 and that is close to the packaged device 310 is connected to the first side surface 3121 of the packaged device 310, and the other end that is of the support body 322 and that is close to the circuit board 200 is connected to the circuit board 200. In another embodiment, the support body 322 may be omitted in the heat sink 320. Specifically, refer to the heat sink 320 shown in FIG. 2 to FIG. 6. That is, the heat sink 320 may include at least one of the following: the heat-dissipation body 321 and the support body 322.

In comparison with the conventional power module, in the power module 300 provided in this embodiment of this application, the packaged device 310 is disposed sideways on the circuit board 200, the packaged device 310 is connected to the circuit board 200 through a bottom surface 3122 with a small area, and the heat sink 320 may be disposed on a side surface with a large area of the packaged device 310. This reduces an occupied area of the circuit board 200, reduces thermal resistance between the packaged device 310 and the heat sink 320, increases a contact area between the packaged device 310 and the heat sink 320, effectively improves heat dissipation effect of the packaged device 310 and the power module 300, and facilitates miniaturization and performance improvement of the power module 300.

The heat sink 320 in the power module 300 provided in this embodiment of this application not only can be used for heat dissipation, but also can be used to support the packaged device 310 to be disposed sideways on the circuit board 200. This improves structural stability of the power module 300.

In an embodiment, the heat sink 320 includes the heat-dissipation body 321 and the support body 322. Specifically, the heat-dissipation body 321 is fixedly connected to the first side surface 3121 of the packaged device 310, one end that is of the support body 322 and that is close to the packaged device 310 is fixedly connected to the heat-dissipation body 321, and the other end that is of the support body 322 and that is close to the circuit board 200 is fixedly connected to the circuit board 200. It may be understood that, the heat-dissipation body 321 and the support body 322 of the heat sink 320 may be configured to support the packaged device 310 to be disposed sideways on the circuit board 200. This improves structural stability of the power module 300.

In an embodiment, the heat sink 320 includes the heat-dissipation body 321 and the support body 322. Specifically, one end that is of the support body 322 and that is close to the packaged device 310 is fixedly connected to the first side surface 3121 of the packaged device 310, and the other end that is of the support body 322 and that is close to the circuit board 200 is fixedly connected to the circuit board 200. It may be understood that the support body 322 of the heat sink 320 may be configured to support the packaged device 310 to be disposed sideways on the circuit board 200. This improves structural stability of the power module 300.

In an embodiment, the heat-dissipation body 321 may be omitted in the heat sink 320. Specifically, one end that is of the support body 322 and that is close to the packaged device 310 is fixedly connected to the first side surface 3121 of the packaged device 310, and the other end that is of the support body 322 and that is close to the circuit board 200 is fixedly connected to the circuit board 200. It may be understood that the support body 322 of the heat sink 320 may be configured to support the packaged device 310 to be disposed sideways on the circuit board 200. This improves structural stability of the power module 300.

The heat sink 320 in the power module 300 provided in this embodiment of this application may include a conductive material or a conductive line, and the third interface 316 of the packaged device 310 may be electrically connected to the circuit board 200 by using the heat sink 320.

In an embodiment, the heat sink 320 includes the heat-dissipation body 321 and the support body 322. The heat-dissipation body 321 and the support body 322 may include a conductive material or a conductive line, and are configured to implement electrical connection between the third interface 316 of the packaged device 310 and the circuit board 200. Specifically, the heat-dissipation body 321 is electrically connected to the third interface 316 on the first side surface 3121, one end that is of the support body 322 and that is close to the heat-dissipation body 321 is electrically connected to the heat-dissipation body 321, and one end that is of the support body 322 and that is close to the circuit board 200 is electrically connected to the circuit board 200.

In an embodiment, the heat sink 320 includes the heat-dissipation body 321 and the support body 322. The support body 322 may include a conductive material or a conductive line, and is configured to implement electrical connection between the third interface 316 of the packaged device 310 and the circuit board 200. Specifically, an end that is of the support body 322 and that is close to the heat-dissipation body 321 is electrically connected to the third interface 316 on the first side surface 3121, and an end that is of the support body 322 and that is close to the circuit board 200 is electrically connected to the circuit board 200.

In an embodiment, the heat-dissipation body 321 may be omitted in the heat sink 320. The support body 322 may include a conductive material or a conductive line, and is configured to implement electrical connection between the third interface 316 of the packaged device 310 and the circuit board 200. Specifically, one end that is of the support body 322 and that is close to the packaged device 310 is electrically connected to the third interface 316, and the other end that is of the support body 322 and that is close to the circuit board 200 is electrically connected to the circuit board 200. That is, the support body 322 of the heat sink 320 may be configured to connect the third interface 316 of the packaged device 310 to the circuit board 200, and provide a parallel line to the first interface 313 or the second interface 314. This can improve reliability of the packaged device 310 and the power module 300.

For example, the first interface 313 and the third interface 316 of the packaged device 310 each include the ground interface. The first interface 313 of the packaged device 310 may be electrically connected to the circuit board 200, and the first interface 313 is electrically connected to the circuit board 200 to form the first ground line. The third interface 316 of the packaged device 310 may be electrically connected to the circuit board 200 by using the heat sink 320, and the third interface 316, the heat sink 320, and the circuit board 200 are electrically connected to form the second ground line. Correspondingly, the first ground line and the second ground line may form the parallel line. That is, the heat sink 320 may be configured to electrically connect the third interface 316 of the packaged device 310 to the circuit board 200, and provide the parallel line to the first interface 313. This can improve reliability of the power module 300. Similarly, the signal transmitted by the third interface 316 of the packaged device 310 may be the same as the signal transmitted by the second interface 314. The heat sink 320 may be configured to electrically connect the third interface 316 of the packaged device 310 to the circuit board 200, to provide the parallel line to the second interface 314. This can improve reliability of the packaged device 310 and the power module 300. That is, the heat sink 320 may be configured to electrically connect the third interface 316 of the packaged device 310 to the circuit board 200, and provide the parallel line to the first interface 313 or the second interface 314. This can improve reliability of the packaged device 310 and the power module 300.

It may be understood that the third interface 316 of the packaged device 310 in the power module 300 provided in this embodiment of this application may be electrically connected to the circuit board 200 by using the heat sink 320, to provide the parallel line to at least one of the following: the first interface 313 and the second interface 314. This can improve reliability of the packaged device 310 and the power module 300.

In comparison with the conventional power module, the heat sink 320 in the power module 300 provided in this embodiment of this application may not only be configured to dissipate heat for the packaged device 310, but also be configured to support the packaged device 310 to be disposed sideways on the circuit board 200, and may be configured to implement electrical connection between the packaged device 310 and the circuit board 200.

FIG. 8 is a schematic diagram of a cross-sectional structure in still another embodiment of a power module according to an embodiment of this application. The structure in this embodiment is roughly the same as the structure shown in FIG. 7, and the same part is not described again. As shown in FIG. 8, a power module 300 includes a packaged device 310, a heat sink 320, a surface-mount device 330, and a heat sink 340.

As shown in FIG. 8, the surface-mount device 330 is disposed on a second side surface 3123 of the packaged device 310. The surface-mount device 330 is electrically connected to a second interface 314 of the packaged device 310. It may be understood that a first side surface 3121 or the second side surface 3123 may be any side surface of the packaged device 310. Correspondingly, the surface-mount device 330 may be disposed on the first side surface 3121 or the second side surface 3123, or may be disposed on both the first side surface 3121 and the second side surface 3123 at the same time. That is, the surface-mount device 330 may be disposed on at least one side surface of the packaged device 310.

The surface-mount device 330 may include one or more of electrical elements such as an inductor, a capacitor, a resistor, or a fuse, and may further include one or more of a packaged chip or a packaged device. For example, the surface-mount device 330 and the packaged device 310 may form a buck circuit. An interface type of the second interface 314 of the packaged device 310 provided in this embodiment of this application may include one or more of the following types: surface-mount, welding, plug-in, or the like. Correspondingly, the surface-mount device 330 may be connected to the second interface 314 in the following manners: surface-mount, welding, plug-in, pin, or the like. It may be understood that the surface-mount device 330 may include one or more of the following: an electrical element, a packaged chip, or a packaged device that uses various types of interfaces, and is not limited to an electrical element that uses a surface-mount interface.

As shown in FIG. 8, the power module 300 includes the heat sink 340. The heat sink 340 is disposed on the second side surface 3123 of the packaged device 310, and is configured to dissipate heat for the surface-mount device 330 and the packaged device 310.

In this embodiment, the heat sink 340 includes a heat-dissipation body 341 and a support body 342. In an embodiment, the heat-dissipation body 341 and the support body 342 of the heat sink 340 are connected to each other. Specifically, one end that is of the support body 342 and that is close to the packaged device 310 is connected to the heat-dissipation body 341, and the other end that is of the support body 342 and that is close to the circuit board 200 is connected to the circuit board 200. In another embodiment, the heat-dissipation body 341 and the support body 342 of the heat sink 340 are separated from each other. Specifically, one end that is of the support body 342 and that is close to the packaged device 310 is connected to the surface-mount device 330 or the second side surface 3123 of the packaged device 310, and the other end that is of the support body 342 and that is close to the circuit board 200 is connected to the circuit board 200. That is, the one end that is of the support body 342 and that is close to the packaged device 310 may be connected to the heat-dissipation body 341, the surface-mount device 330, or the second side surface 3123 of the packaged device 310, and the other end that is of the support body 342 and that is close to the circuit board 200 may be connected to the circuit board 200.

In this embodiment, the heat-dissipation body 341 of the heat sink 340 is connected to the surface-mount device 330, one end that is of the support body 342 and that is close to the packaged device 310 is connected to the heat-dissipation body 341, and the other end that is of the support body 342 and that is close to the circuit board 200 is connected to the circuit board 200. In another embodiment, the heat-dissipation body 341 may be connected to the second side surface 3123 of the packaged device 310. In another embodiment, the heat-dissipation body 341 may be connected to both the second side surface 3123 of the packaged device 310 and the surface-mount device 330 at the same time. That is, the heat-dissipation body 341 may be connected to the surface-mount device 330 or the second side surface 3123 of the packaged device 310.

In comparison with the conventional power module, in the power module 300 provided in this embodiment of this application, a distance between the heat sink 340 and the surface-mount device 330 or the second side surface 3123 of the packaged device 310 is short, so that thermal resistance between the heat sink 340 and the surface-mount device 330 or the second side surface 3123 of the packaged device 310 can be reduced. This improves heat dissipation efficiency of the power module 300.

The heat sink 340 in the power module 300 provided in this embodiment of this application may not only be configured to implement a heat dissipation function, but also be configured to support the packaged device 310 to be disposed sideways on the circuit board 200, or may be configured to implement fixed connection between the packaged device 310 and the circuit board 200.

As shown in FIG. 8, the heat sink 340 includes the heat-dissipation body 341 and the support body 342. In an embodiment, the heat-dissipation body 341 is fixedly connected to the surface-mount device 330 or the second side surface 3123 of the packaged device 310, one end that is of the support body 342 and that is close to the heat-dissipation body 341 is fixedly connected to the heat-dissipation body 341, and the other end that is of the support body 342 and that is close to the circuit board 200 is fixedly connected to the circuit board 200, so as to support the packaged device 310 to be disposed sideways on the circuit board 200. This improves structural stability of the power module 300. In another embodiment, one end that is of the support body 342 and that is close to the heat-dissipation body 341 is fixedly connected to the surface-mount device 330 or the second side surface 3123 of the packaged device 310, and the other end that is of the support body 342 and that is close to the circuit board 200 is fixedly connected to the circuit board 200, so as to support the packaged device 310 to be disposed sideways on the circuit board 200. This improves structural stability of the power module 300. That is, the one end that is of the support body 342 and that is close to the packaged device 310 may be fixedly connected to the heat-dissipation body 341, the surface-mount device 330, or the second side surface 3123 of the packaged device 310, and the other end that is of the support body 342 and that is close to the circuit board 200 may be fixedly connected to the circuit board 200.

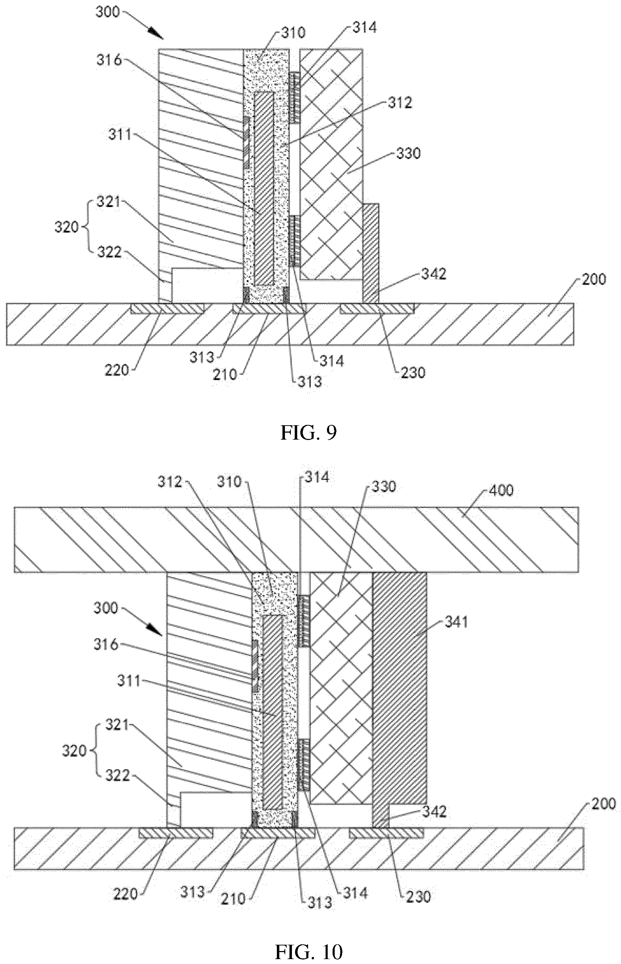

FIG. 9 is a schematic diagram of a cross-sectional structure in yet another embodiment of a power module according to an embodiment of this application. The structure in this embodiment is roughly the same as the structure shown in FIG. 8, and the same part is not described again.

As shown in FIG. 9, a heat-dissipation body 341 may be omitted in a heat sink 340. In this embodiment, one end that is of the support body 342 and that is close to the packaged device 310 is fixedly connected to the surface-mount device 330, and the other end that is of the support body 342 and that is close to the circuit board 200 is fixedly connected to the circuit board 200. In this case, the support body 342 may be configured to implement fixed connection between the surface-mount device 330 and the circuit board 200, and may be configured to support the packaged device 310 and the power module 300 to be disposed sideways on the circuit board 200. In an embodiment, one end that is of the support body 342 and that is close to the packaged device 310 may be fixedly connected to the second side surface 3123 of the packaged device 310, and the other end that is of the support body 342 and that is close to the circuit board 200 is fixedly connected to the circuit board 200. In this case, the support body 342 may be configured to implement fixed connection between the packaged device 310 and the circuit board 200, and may support the packaged device 310 and the power module 300 to be disposed sideways on the circuit board 200. That is, the one end that is of the support body 342 and that is close to the packaged device 310 may be fixedly connected to the surface-mount device 330 or the second side surface 3123 of the packaged device 310, so as to support the packaged device 310 and the power module 300 to be disposed sideways on the circuit board 200. This improves structural stability of the power module 300.

The heat sink 340 in the power module 300 provided in this embodiment of this application may include a conductive material or a conductive line. The surface-mount device 330 or the second interface 314 of the packaged device 310 may be electrically connected to the circuit board 200 by using the heat sink 340.

As shown in FIG. 8, the power module 300 includes a heat sink 340. The heat sink 340 is disposed on the second side surface 3123 of the packaged device 310, and is configured to dissipate heat for the surface-mount device 330 and the packaged device 310. The heat sink 340 includes a heat-dissipation body 341 and a support body 342. In an embodiment, the heat-dissipation body 341 may be electrically connected to the second interface 314 or the surface-mount device 330, one end that is of the support body 342 and that is close to the packaged device 310 is electrically connected to the heat-dissipation body 341, and the other end that is of the support body 342 and that is close to the circuit board 200 is electrically connected to the circuit board 200. In another embodiment, the third interface 316 may be disposed on the second side surface 3123 of the packaged device 310. In an embodiment, the heat-dissipation body 341 is electrically connected to the third interface 316, one end that is of the support body 342 and that is close to the packaged device 310 is electrically connected to the heat-dissipation body 341, and the other end that is of the support body 342 and that is close to the circuit board 200 is electrically connected to the circuit board 200. That is, the heat-dissipation body 341 of the heat sink 340 may be electrically connected to at least one of the following: the surface-mount device 330, the second interface 314 of the packaged device 310, and the third interface 316.

In another embodiment, one end that is of the support body 342 and that is close to the packaged device 310 may be electrically connected to the second interface 314 or the surface-mount device 330, and the other end that is of the support body 342 and that is close to the circuit board 200 is electrically connected to the circuit board 200. In another embodiment, the third interface 316 may be disposed on the second side surface 3123 of the packaged device 310. In an embodiment, one end that is of the support body 342 and that is close to the packaged device 310 may be electrically connected to the third interface 316, and the other end that is of the support body 342 and that is close to the circuit board 200 is electrically connected to the circuit board 200. That is, the one end that is of the support body 342 and that is close to the packaged device 310 may be electrically connected to at least one of the following: the surface-mount device 330, the second interface 314 of the packaged device 310, and the third interface 316.

As shown in FIG. 9, the heat-dissipation body 341 is omitted in the heat sink 340. In this embodiment, one end that is of the support body 342 and that is close to the packaged device 310 is electrically connected to the second interface 314 or the surface-mount device 330, and the other end that is of the support body 342 and that is close to the circuit board 200 is electrically connected to the circuit board 200. In another embodiment, the third interface 316 may also be disposed on the second side surface 3123 of the packaged device 310, an end that is of the support body 342 and that is close to the packaged device 310 may also be electrically connected to the third interface 316, and the other end that is of the support body 342 and that is close to the circuit board 200 is electrically connected to the circuit board 200. That is, the one end that is of the support body 342 of the heat sink 340 and that is close to the packaged device 310 may be electrically connected to at least one of the following: the second interface 314, the third interface 316, and the surface-mount device 330, and the other end that is of the support body 342 and that is close to the circuit board 200 is electrically connected to the circuit board 200.

In comparison with the conventional power module, the surface-mount device 330 or the second interface 314 or the third interface 316 of the packaged device 310 in the power module 300 provided in this embodiment of this application may be electrically connected to the circuit board 200 by using the heat sink 340, so that the power module 300 is connected to another electrical element of the circuit board 200. This improves practicability of the power module 300.

Functions and structures of a heat sink 320 and the heat sink 340 in the power module 300 provided in this embodiment of this application are roughly the same. In some embodiments, the heat sink 340 and the heat sink 320 may be replaced with each other. In some embodiments, heat sinks (320, 340) may include heat-dissipation bodies (321, 341) and support parts (322, 342). In some embodiments, the heat-dissipation bodies (321, 341) or the support parts (322, 342) may be omitted in the heat sinks (320, 340). That is, the heat sinks (320, 340) may include at least one of the heat-dissipation bodies (321, 341) and the support parts (322, 342).

The power module 300 provided in this embodiment of this application has a plurality of embodiments. In an embodiment, the power module 300 includes a packaged device 310 and a surface-mount device 330, and the surface-mount device 330 may be disposed on at least one side surface of the packaged device 310. In an embodiment, the power module 300 includes a packaged device 310 and heat sinks (320, 340), and the heat sinks (320, 340) may be disposed on at least one side surface of the packaged device 310. In an embodiment, the power module 300 includes a packaged device 310, heat sinks (320, 340), and a surface-mount device 330. The heat sinks (320, 340) and the surface-mount device 330 may be disposed on a same side surface of the packaged device 310. In an embodiment, the power module 300 includes a packaged device 310, heat sinks (320, 340), and a surface-mount device 330. The heat sinks (320, 340) and the surface-mount device 330 may be disposed on different side surfaces of the packaged device 310. That is, the power module 300 may include at least one of the heat sinks (320, 340) or the surface-mount device 330, and the heat sinks (320, 340) or the surface-mount device 330 may be disposed on at least one side surface of the packaged device 310.

In comparison with the conventional power module, the packaged device 310 of the power module 300 provided in this embodiment of this application is connected to the circuit board 200 through the bottom surface 3122 with a small area, so that the packaged device 310 can be disposed sideways on the circuit board 200. This reduces an occupied area of the circuit board 200, reduces impact of a parasitic parameter, and facilitates miniaturization and performance improvement of the power module 300. In addition, the heat sink 320 and the surface-mount device 330 may be disposed on the first side surface 3121 and the second side surface 3123 that have a large area and that are of the packaged device 310 in the power module 300, so that not only heat dissipation efficiency of the power module 300 can be improved, but also practicability of the power module 300 can be improved.

As shown in FIG. 2, the electronic apparatus 1000 provided in this embodiment of this application includes a circuit board 200 and a power module 300. The power module 300 is disposed on the circuit board 200. The power module 300 and the circuit board 200 are connected in a plurality of manners. In an embodiment, the packaged device 310 in the power module 300 is connected to the circuit board 200. In an embodiment, the packaged device 310 and the heat sink 320 in the power module 300 are connected to the circuit board 200. In an embodiment, the packaged device 310, the heat sink 320, and the heat sink 340 in the power module 300 are connected to the circuit board 200. Specific descriptions are provided below.

In an embodiment, the packaged device 310 in the power module 300 is connected to the circuit board 200. As shown in FIG. 3, the packaged device 310 is disposed sideways on the circuit board 200, and the circuit board 200 includes a first connection interface 210, configured to connect to a first interface 313 of the packaged device 310. In an embodiment, the bottom surface 3122 of the packaged device 200 is fixedly connected to the circuit board 200, and the first interface 313 is in contact with the first connection interface 210, to implement electrical connection between the packaged device 310 and the circuit board 20. In an embodiment, the first interface 313 of the packaged device 310 is fixedly connected to the first connection interface 210, and is not only configured to implement electrical connection between the first interface 313 and the first connection interface 210, but also configured to support the packaged device 310 to be disposed sideways on the circuit board 200. That is, the first connection interface 210 may be configured to electrically connect to the first interface 313 of the packaged device 310, and may be configured to support the packaged device 310 to be disposed sideways on the circuit board 200.

The packaged device 310 of the power module 300 in the electronic apparatus 1000 provided in this embodiment of this application is disposed sideways on the circuit board 200 through the bottom surface 3122, so that the packaged device 310 is electrically connected to the circuit board 200 at a short distance. This reduces a parasitic parameter and improves electrical performance of the electronic apparatus 1000. In addition, the packaged device 310 of the power module 300 is disposed sideways on the circuit board 200 through a bottom surface 3122 with a small area. This reduces an area occupied by the circuit board 200, and facilitates miniaturization of the entire electronic apparatus 1000. A second connection interface 220 of the circuit board 200 in the electronic apparatus 1000 provided in this embodiment of this application may further support the packaged device 310 to be disposed sideways on the circuit board 200. This improves reliability of the electronic apparatus 1000.

In an embodiment, the packaged device 310 and the heat sink 320 in the power module 300 are connected to the circuit board 200. As shown in FIG. 7, the circuit board in this embodiment is roughly the same as the circuit board shown in FIG. 2, and the same part is not described again. The circuit board 200 in this embodiment further includes a second connection interface 220, configured to connect a support body 322 of the heat sink 320. In an embodiment, the second connection interface 220 is fixedly connected to the support body 322 of the heat sink 320, so that the packaged device 310 can be supported to be disposed sideways on the circuit board 200, and structural stability of the electronic apparatus 1000 can be improved. In an embodiment, the heat sink 320 includes a conductive material or a conductive line. The second connection interface 220 is electrically connected to a third interface 316 of the packaged device 310 by using the heat sink 320, and may provide a parallel line to the first interface 313 or the second interface 314 of the packaged device 310. This can improve reliability of the electronic apparatus 1000. That is, the second connection interface 220 may be electrically connected to the third interface 316 of the packaged device 310 by using the heat sink 320, and may provide the parallel line to the first interface 313 or the second interface 314 of the packaged device 310.

In an embodiment, the packaged device 310, the heat sink 320, and the heat sink 340 in the power module 300 are connected to the circuit board 200. As shown in FIG. 8, the circuit board in this embodiment is roughly the same as the circuit board shown in FIG. 7, and the same part is not described again. A difference is that the circuit board 200 in this embodiment further includes a third connection interface 230, configured to connect to a support body 342 of the heat sink 340. In an embodiment, the third connection interface 230 is fixedly connected to the support body 322 of the heat sink 324, so that the packaged device 310 and the power module 300 can be securely connected to the circuit board 200, and structural stability of the electronic apparatus 1000 can be improved. In an embodiment, the heat sink 340 includes a conductive material or a conductive line. The third connection interface 230 is electrically connected to the surface-mount device 330 or the second interface 314 of the packaged device 310 by using the heat sink 340, so that the power module 300 is connected to another electrical element of the circuit board 200. This can improve practicability of the electronic apparatus 1000. That is, the third connection interface 230 may be electrically connected to the surface-mount device 330 or the second interface 314 of the packaged device 310 by using the heat sink 340. This can improve practicability of the electronic apparatus 1000.

In the electronic apparatus 1000 provided in this embodiment of this application, the heat sink 320 may be disposed on the first side surface 3121 or the second side surface 3123 that has a large area and that is of the packaged device 310 in the power module 300. This improves heat dissipation efficiency of the power module 300, and prevents heat from being transferred to the circuit board 200 to cause board burning, and facilitates miniaturization and performance improvement of the electronic apparatus 1000. The second connection interface 220 or the third connection interface 230 of the circuit board 200 in the electronic apparatus 1000 provided in this embodiment of this application may be electrically connected to the packaged device 310 by using the heat sinks (320, 340). This can improve reliability and practicability of the electronic apparatus 1000.

FIG. 10 is a schematic diagram of a structure in another embodiment of an electronic apparatus according to an embodiment of this application. As shown in FIG. 10, an electronic apparatus 1000 includes a circuit board 200, a power module 300, and a system heat sink 400. The power module 300 is disposed on the circuit board 200, and the system heat sink 400 is disposed on the power module 300 in a stacked manner. The system heat sink 400 is in contact with at least one of a heat sink 320, a packaged device 310, and a surface-mount device 330. It may be understood that, the packaged device 310 and the surface-mount device 330 in the power module 300 may not only dissipate heat by using the heat sink 320, but also dissipate heat by using the system heat sink 400. This improves heat dissipation efficiency of the entire electronic apparatus 1000. In an embodiment, the electronic apparatus 1000 may further include a housing 100. The housing 100 is configured to accommodate the circuit board 200, the power module 300, and the system heat sink 400.

It should be noted that embodiments in this application and the features in embodiments may be mutually combined in the case of no conflict, and any combination of features in different embodiments also falls within the protection scope of this application. In other words, the foregoing described plurality of embodiments may be combined with each other based on an actual requirement.

It should be noted that all the foregoing accompanying drawings are examples of this application, and do not represent actual sizes of products. In addition, a size proportion relationship between components in the accompanying drawings is not intended to limit an actual product in this application.

The foregoing descriptions are only some embodiments and implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A packaged device, comprising a bottom surface and a plurality of side surfaces, wherein the packaged device comprises:
a chip module;
a package body, configured to package the chip module;
a first interface, configured to connect to a circuit board, wherein the first interface is disposed on the bottom surface, or the first interface is disposed on a part that is of at least one side surface and that is close to the bottom surface; and
a second interface, configured to connect to a surface-mount device, wherein the second interface is disposed on at least one side surface, wherein
the bottom surface faces the circuit board, and an area of at least one side surface is greater than that of the bottom surface.

2. The packaged device according to claim 1, wherein the first interface is configured to transmit a first type signal, and the first type signal comprises at least one of the following signal transmitted between the packaged device and the circuit board: a power signal, a ground signal, or a control signal.

3. The packaged device according to claim 1 or 2, wherein the second interface is configured to transmit a second type signal, and the second type signal comprises at least one of the following signal transmitted between the packaged device and the surface-mount device: a voltage signal or a current signal.

4. The packaged device according to any one of claims 1 to 3, wherein the packaged device comprises a third interface, and the third interface is disposed on at least one side surface.

5. The packaged device according to any one of claims 1 to 4, wherein the third interface is configured to connect to the circuit board, and provide a parallel line to the first interface or the second interface.

6. The packaged device according to any one of claims 1 to 5, wherein the plurality of side surfaces of the packaged device comprise a first side surface and a second side surface, the second interface is disposed on the second side surface, and the third interface is disposed on the first side surface.

7. A power module, wherein the power module comprises the packaged device according to any one of claims 1 to 6 and at least one of a heat sink or a surface-mount device, the heat sink is disposed on at least one side surface of the packaged device, and the surface-mount device is connected to a second interface of the packaged device.

8. The power module according to claim 7, wherein the heat sink comprises a heat-dissipation body, and the heat-dissipation body is connected to the surface-mount device or the at least one side surface.

9. The power module according to claim 7 or 8, wherein the heat sink comprises a support body, one end of the support body is connected to the heat-dissipation body, the surface-mount device, or the at least one side surface, and the other end of the support body is connected to a circuit board.

10. The power module according to any one of claims 7 to 9, wherein the surface-mount device or the second interface of the packaged device is electrically connected to the circuit board by using the heat sink.

11. The power module according to any one of claims 7 to 10, wherein the packaged device comprises a third interface, and the third interface is electrically connected to the circuit board by using the heat sink.

12. The packaged device according to any one of claims 7 to 11, wherein a plurality of side surfaces of the packaged device comprise a first side surface and a second side surface, the heat sink is disposed on the first side surface, and the surface-mount device and the second interface of the packaged device are disposed on the second side surface.

13. An electronic apparatus, comprising a circuit board and the power module according to any one of claims 7 to 12, wherein the power module is disposed on the circuit board, a packaged device is disposed sideways on the circuit board, the circuit board comprises a first connection interface, and the first connection interface is configured to connect to a first interface of the packaged device.

14. The electronic apparatus according to claim 13, wherein the power module comprises a heat sink, the circuit board comprises a second connection interface or a third connection interface, and the second connection interface or the third connection interface is configured to connect to a support body of the heat sink.

15. The electronic apparatus according to claim 14, wherein the packaged device comprises a third interface, and the second connection interface is electrically connected to the third interface of the packaged device by using the heat sink.

16. The electronic apparatus according to claim 14 or 15, wherein the power module comprises a surface-mount device, and the third connection interface is electrically connected to the surface-mount device by using the heat sink.

17. The electronic apparatus according to any one of claims 14 to 16, wherein the third connection interface is electrically connected to a second interface of the packaged device by using the heat sink.
